# EUROPÄISCHE PATENTANMELDUNG

(11) **EP 1 612 566 A1**
(43) Veröffentlichungstag der Anmeldung: **04.01.2006**
(21) Anmeldenummer: 05013065.7
(22) Anmeldetag: 17.06.2005
(51) Int. Cl.: G01R 11/04, H01R 13/627

(54) **Sperre zur Blockierung eines Funktionselements**

(30) Priorität: 29.06.2004 DE 102004031556; 12.11.2004 DE 102004054887
(71) Anmelder: Hager Electro GmbH, 66131 Saarbrücken (DE)
(72) Erfinder: Kelaiditis, Konstantin, Dr.-Ing., 66386 St. Ingbert (DE)
(74) Vertreter: Bernhardt, Winfrid

(57) **Zusammenfassung**

Die Erfindung betrifft eine Sperre zur Blockierung eines Funktionselements in einer gewünschten Stellung, insbesondere zur Blockierung eines Funktionselements (10) eines Stromzähleranschlussplatzes oder/und eines Stromzählers selbst, mit einem Sperrglied (100), das zur Bildung eines das Funktionselement blockierenden Anschlags in einen Steckkanal (74) einführbar und in dem Steckkanal arretierbar ist. Gemäß der Erfindung rastet das Sperrglied (100) in dem Steckkanal (74) unlösbar ein und ist zur Lösung der Blockierung des Funktionselements zu zertrennen.

## Beschreibung

Die Erfindung betrifft eine Sperre zur Blockierung eines Funktionselements in einer gewünschten Stellung, insbesondere zur Blockierung eines Funktionselements eines Stromzähleranschlussplatzes oder/und eines Stromzählers selbst, mit einem Sperrglied, das zur Bildung eines das Funktionselement blockierenden Anschlags in einen Steckkanal einführbar und in dem Steckkanal arretierbar ist.

Eine solche Sperre ist in der deutschen Patentanmeldung 10 2004 025 605.5 beschrieben. Als Sperrelement dient ein in der Stecköffnung verankerbares Steckschloss, das eine dem Anschluss des Stromzählers dienende, verschiebbare Platte in einer Stellung blockiert, in welcher eine Überbrückung zwischen den Anschlusskontakten für den Stromzähler aufgehoben ist.

Der Erfindung liegt die Aufgabe zugrunde, eine gegenüber diesem Stand der Technik konstruktiv vereinfachte Sperre der eingangs erwähnten Art zu schaffen.

Die diese Aufgabe lösende Sperre nach der Erfindung ist dadurch gekennzeichnet, dass das Sperrglied in dem Steckkanal unlösbar einrastet und zur Lösung der Blockierung des Funktionselements zu zertrennen ist.

Vorteilhaft kommt einem solchen Sperrglied nach der Erfindung sowohl eine Sperrals auch Plombierfunktion zu. Manipulationen am Zählerplatz sind anhand der Trennstelle oder Fehlens des Sperrgliedes sofort erkennbar. Die Lösung der Blockierung durch Zertrennen des Sperrgliedes ist nur befugten Personen vorbehalten.

Während es denkbar ist, im Steckkanal eine Nase vorzusehen, welche in eine Ausnehmung am Sperrglied einrastet, weist in einer bevorzugten Ausführungsform der Erfindung das Sperrglied eine an einer Hinterschneidung des Steckkanals einrastende Nase oder dort einrastenden Widerhaken auf.

Am Sperrglied kann eine Sollbruchstelle gebildet sein. Vorzugsweise ist das Sperrglied zur Zertrennung außerhalb des Steckkanals vorgesehen, wobei ein in den Steckkanal einführbarer Schaft des Sperrgliedes durch Zertrennung des Sperrgliedes voneinander lösbare Schaftteile aufweist. Insbesondere kann der Schaft mit einem Längsschlitz versehen sein, wobei der Schaft bei Zertrennung des Sperrgliedes außerhalb des Steckkanals in zwei, einzeln aus dem Steckkanal herausziehbare Schaftteile zerfällt. Einer der Schaftteile, ohne Widerhaken, lässt sich dann sofort aus dem Steckkanal entfernen. Ein mit einem Widerhaken versehener Schaftteil lässt sich innerhalb des Steckkanals quer so verschieben, dass der Widerhaken aus seiner Verhakungsstellung gelöst wird.

In einer Ausführungsform der Erfindung weist einer der Schaftteile einen den Widerhaken umfassenden, U-förmigen Abschnitt auf, welcher über einen außerhalb des Steckkanals angeordneten, bügelförmigen Verbindungsabschnitt mit dem anderen Schaftteil verbunden ist. Vorzugsweise liegen die Schaftteile gegeneinander an, so dass der eingesteckte Schaft in seiner Breite nicht verändert werden kann und eine Lösung der Einrastung durch eine solche Veränderung ausgeschlossen ist. Zweckmäßig ist der andere Schaftteil keilförmig mit einer einem U-Schenkel des U-förmigen Abschnitts gegenüberliegenden Keilfläche ausgebildet.

Zwischen den Schaftteilen können starre oder/und flexible Verbindungsabschnitte gebildet sein. Z.B. ist eine Verbindung der Schaftteile über ein Filmscharnier denkbar.

Beide Schaftteile können oder nur ein Schaftteil kann mit einem scheibenförmigen Griffteil des Sperrgliedes verbunden sein, wobei der Griffteil plakettenartig Aufschriften, z.B. Nummern oder Angaben über den Versorgungsnetzbetreiber, aufweisen kann.

Die Sollbruchstelle ist vorzugsweise zwischen den Schaftteilen und dem Griff angeordnet.

In weiterer vorteilhafter Ausgestaltung der Erfindung weist das Sperrglied einen gegen den Öffnungsrand des Steckkanals anlegbaren Anschlag auf, durch welchen die erforderliche Eindringtiefe des Schafts in den Steckkanal festgelegt ist.

In weiterer Ausgestaltung der Erfindung weist der Griffteil eine Öffnung für die Aufnahme einer in der Öffnung fixierbaren Plombe auf. In die Öffnung kann ein Stift hineinragen, welcher aus der Öffnung heraus abbiegbar ist, so dass sich eine Plombe darauf aufstecken und die Plombe unter Rückbiegung des Stiftes in die Öffnung einschwenken und dort zur Verbindung mit dem Griffteil verpressen lässt.

Die Erfindung soll nun anhand von Ausführungsbeispielen und der beiliegenden, sich auf diese Ausführungsbeispiele beziehenden Zeichnungen näher erläutert werden. Es zeigen:
Fig. 1 einen auf einen herkömmlichen Zählerplatz aufsetzbaren Stromzähleradapter für einen elektronischen Stromzähler, bei welchem eine Sperre nach der Erfindung zum Einsatz kommen kann,
Fig. 2 den Adapter von Fig. 1 in einer Explosionsdarstellung ohne stromleitende Teile,
Fig. 3 ein erstes Ausführungsbeispiel für ein Sperrglied nach der Erfindung,
Fig. 4 das Sperrglied von Fig. 3 eingesetzt in einen Steckkanal,
Fig. 5 und 9 weitere Ausführungsbeispiele für Sperrglieder nach der Erfindung, und
Fig. 10 bis 12 weitere Beispiele für die Anwendung von Sperrgliedern nach der Erfindung.

Ein an einen herkömmlichen Zählerplatz montierbarer Adapter 1 für einen (nicht gezeigten) Stromzähler weist einen vorderen Gehäuseteil 2 mit einer Zählertragplatte 4 und einen hinteren Gehäuseteil 3 in Form eines halb offenen Kastens 5 auf.

An die Zählertragplatte 4 und den halb offenen Kasten 5 schließt sich jeweils ein Abschnitt 6 bzw. 7 für die Bildung eines Anschlussleistenteils 50 des Adapters 1 an.

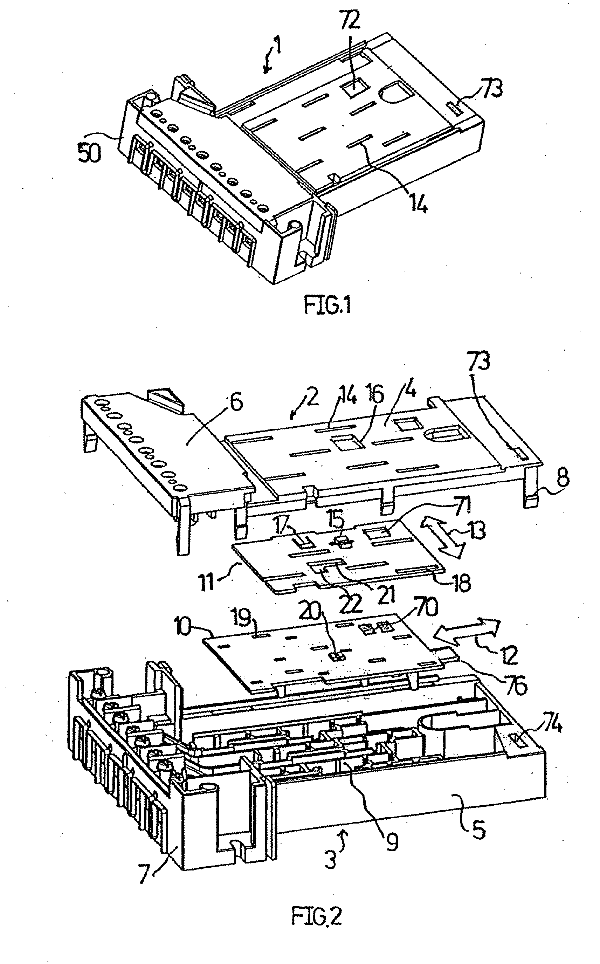

Wie aus Fig. 2 hervorgeht, ist der vordere Gehäuseteil 2 mit dem hinteren Gehäuseteil 3 über einrastende Stecknasen 8 verbindbar.

Vom Boden des unteren Gehäuseteils stehen stegförmig Isolierteile 9 vor, zwischen denen elektrischen Leiter angeordnet und gehalten sind.

Zwischen den Isolierteilen 9 und der Zählertragplatte 4 sind eine Mitnehmerplatte 10 und eine Verschlussplatte 11 angeordnet.

Von den zur Zählertragplatte 4 parallelen Platten 10 und 11 ist die Mitnehmerplatte 10 an dem hinteren Teil 3 des Zählergehäuses geführt und in Richtung eines Pfeils 12 hin und her verschiebbar. Die an der Rückseite der Zählertragplatte 4 geführte Verschlussplatte 11 lässt sich gemäß Pfeil 13 hin und her verschieben.

Die Zählertragplatte 4 weist insgesamt sieben gleich lange Schlitze 14 auf, in welche streifenförmige, von der Unterseite eines Stromzählers vorstehende Kontaktelemente einführbar sind. Sechs Kontaktelemente sind für drei Stromphasen vorgesehen, ein Kontaktelement bildet den zum Betrieb des Stromzählers selbst erforderlichen Nullleiter.

Die Verschlussplatte 11 weist zu den Schlitzen 14 deckungsgleiche Schlitze 18 bzw. Randausnehmungen auf. Von der Verschlussplatte steht eine Nase 15 in ein Fenster 16 in der Zählertragplatte vor. Über die Nase lässt sich die Verschlussplatte 11 gemäß Pfeil 13 verschieben. An der Nase 15 sind ferner Einrichtungen zur Plombierung der Verschlussplatte 11 in ihrer Verschlussstellung vorgesehen, in welcher sie sämtliche Öffnungen in der Tragplatte 4 von hinten verschließt. Eine Rastnase 17 rastet in der Verschlussstellung an der Rückseite der Zählertragplatte 4 ein.

Die Mitnehmerplatte 10 weist den Schlitzen 14 in der Zählertragplatte 4 entsprechende Schlitze 19 auf, die jedoch kürzer als die Schlitze 14 sind und deren Länge in Verschiebungsrichtung gemäß Pfeil 12 gleich der Breite der streifenförmigen, von der Rückseite des (nicht gezeigten) Stromzählers vorstehenden Kontaktelementen ist. Eine Nase 20 auf der Mitnehmerplatte 10 ragt in eine Öffnung 21 in der Verschlussplatte 11 hinein, wobei die Öffnung 21 eine Aufweitung 22 aufweist. Die Verschlussplatte 11 lässt sich nur dann gemäß Pfeil 13 verschieben, wenn die Mitnehmerplatte 10 so verschoben ist, dass die Nase 20 in die Aufweitung 22 hinein ausweichen kann.

In Fig. 2 weist das Bezugszeichen 70 auf zwei verschieden farbige Felder auf der Mitnehmerplatte 10 hin, z.B. ein grünes und ein rotes Feld. Je nach Stellung der Mitnehmerplatte 10 ist eines der beiden Felder durch ein Fenster 71 in der Verschlussplatte 11 und ein Fenster 72 in der Zählertragplatte 4 hindurch sichtbar.

Die Funktion des vorangehend beschriebenen Adapters geht aus der hier einbezogenen Anmeldung 10 2004 025 605.5 hervor.

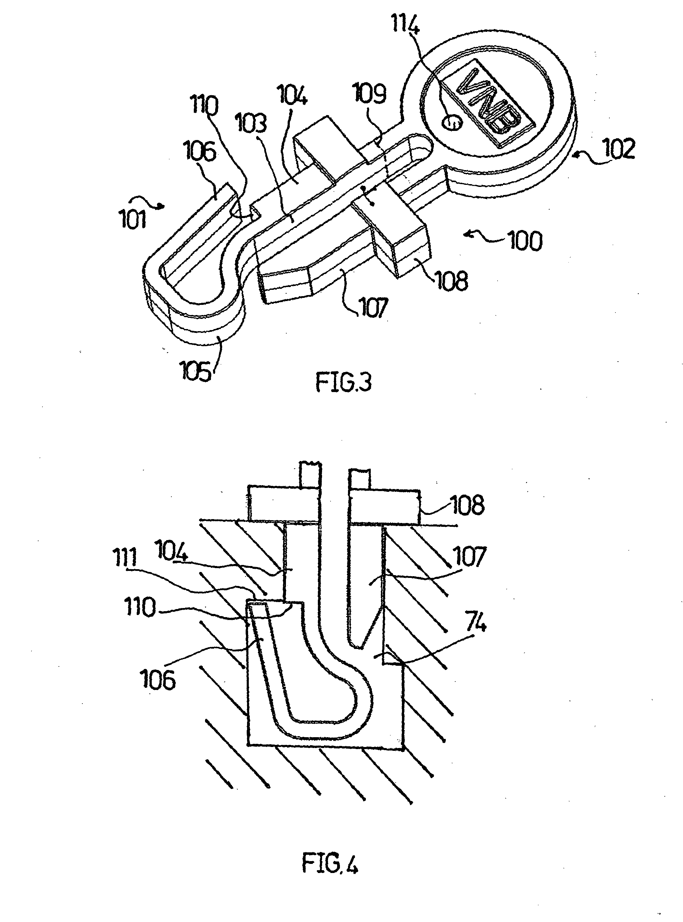

Wie Fig. 1 und 2 ferner erkennen lassen, ist in der Zählertragplatte 4 eine Öffnung 73 für ein in Fig. 3 gezeigtes Sperrglied 100 vorgesehen, welches sich in einen Steckkanal 74 im Kastenteil 5 einschieben und dort befestigen lässt. Im eingeschobenen Zustand bildet das Sperrglied 100 einen Anschlag für eine mit der Mitnehmerplatte 10 verbundene Zunge 76, welcher eine Verschiebung der Mitnehmerplatte 10 verhindert. Eine solche Sperre könnte auch für die Verschlussplatte 11 vorgesehen sein.

Es wird nun auf Fig. 3 Bezug genommen, wo ein in die Öffnung 73 einführbares Sperrglied 100 mit einem Schaft 101 und einem scheibenförmigen Griff 102 gezeigt ist.

Der durch einen Trennschlitz 103 geteilte Schaft 101 weist einen ersten Schaftteil 104 auf, an welchen ein Stufenabsatz 110 sowie unter Bildung einer Ausbauchung 105 ein elastischer Widerhaken 106 angeformt sind. Ein zweiter Schaftteil 107 ist gegenüber dem ersten Schaftteil verkürzt. Der Schaft 101 ist zu dem Griff 102 hin durch einen auf beiden Seiten des Schafts überstehenden Anschlag 108 begrenzt.

Das Bezugszeichen 109 weist auf eine zwischen dem Schaft 101 und dem Griff 102 gebildete Sollbruchstelle hin.

Zur Blockierung der Mitnehmerplatte 10 lässt sich das Sperrglied 100 durch die Öffnung 73 hindurch in den Steckkanal 74 einführen. Während der Einführung gibt der elastische Widerhaken 106 nach und legt sich im Stufenabsatz 110 gegen den Schaftteil 104 an. In der in Fig. 4 gezeigten Stellung ist der Widerhaken 106 hinter einer Hinterschneidung 111 des Steckkanals 74 eingerastet. Die Winkelstellung des Widerhakens 106 zur Steckrichtung ist so steil, dass der Widerhaken bei dem Versuch, das Sperrglied aus dem Steckkanal herauszuziehen, weitgehend auf Druck belastet wird und nicht abgebogen werden kann. Gewaltsames Herausziehen führt unvermeidbar zur Zerstörung des Sperrgliedes. Die Anordnung des Anschlags 108 relativ zur Spitze des Widerhakens 106 ist so bemessen, dass das eingerastete Sperrglied weitgehend spielfrei in dem Steckkanal 74 sitzt.

Das Sperrglied 100 kann durch Bruch oder Zerschneiden entfernt werden. Dies ist nur befugtem Personal vorbehalten.

Zum Entfernen des Sperrgliedes 100 wird der Griff 102 abgebrochen oder zerschnitten. Durch Bruch an der Sollbruchstelle 109 sind die beiden Schaftteile 104 und 107 voneinander losgelöst und stehen aus der Öffnung 73 heraus vor. Der Schaftteil 107 kann ohne weiteres aus dem Steckkanal 74 herausgezogen werden. Nach Entfernung des Schaftteils 107 lässt sich der Schaftteil 104 quer zum Steckkanal 74 bewegen, so dass der Widerhaken 106 aus der Verhakungsstellung mit der Hinterschneidung 111 gerät und der Schaftteil 104 nun ebenfalls aus dem Steckkanal 74 herausgezogen werden kann. Die an beiden Schaftteilen 104 und 107 vorgesehenen, den Anschlag 108 bildenden Absätze sorgen dafür, dass die Schaftteile nach Zertrennung des Sperrgliedes nicht in den ggf. nach unten offenen Steckkanal hineinfallen können.

Der Anschlag am Schaftteil 104 ist so breit, dass bei herausgezogenem Schaftteil 107 der Schaftteil 104 nicht in den Steckkanal 74 hineinrutschen kann.

Das Bezugszeichen 114 weist auf ein Loch für die Durchführung eines Plombierdrahtes hin.

In den folgenden Figuren sind gleiche oder gleichwirkende Teile mit derselben Bezugszahl wie in Fig. 3 und 4 bezeichnet, wobei der betreffenden Bezugszahl der Buchstabe a bzw. b beigefügt ist.

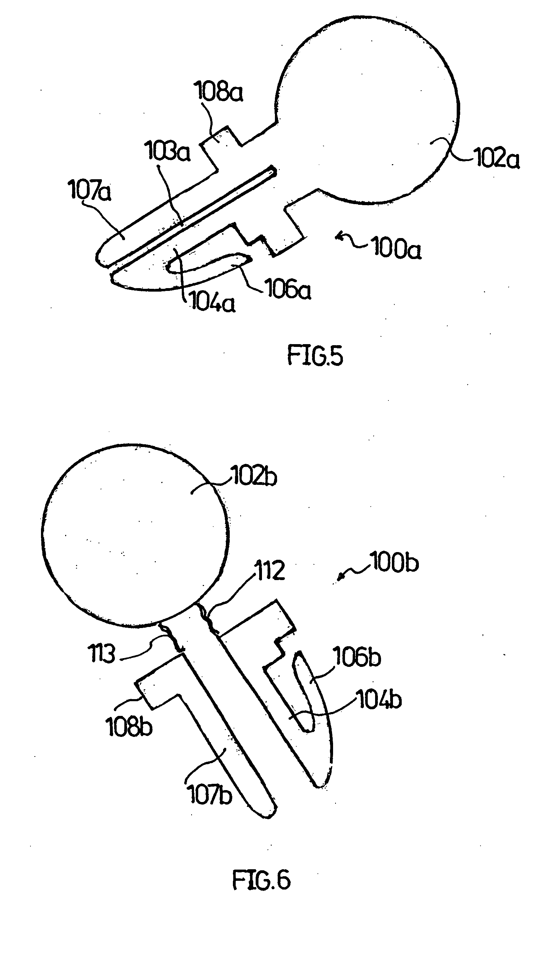

Das Ausführungsbeispiel von Fig. 5 unterscheidet sich von dem vorangehenden Ausführungsbeispiel dadurch, dass Schaftteile 104a und 107a gleich lang ausgebildet und an den Schaftteil 104a ein Widerhaken 106a ohne Ausbauchung in Richtung zu dem anderen Schaftteil angeformt ist.

Bei dem Ausführungsbeispiel von Fig. 6 ist ein scheibenförmiger Griff 102b über flexible Abschnitte 112 und 113 mit je einem Schaftteil 104b und einem Schaftteil 107b verbunden. Die flexiblen Abschnitte 112 und 113 bilden Sollbruchstellen.

Abweichend von dem gezeigten Ausführungsbeispiel könnte direkt zwischen den Schaftteilen ein flexibler Abschnitt, z.B. ein Filmscharnier, gebildet und ein Griff starr mit einem Schaftteile verbunden sein.

Bei den Sperrgliedern kann es sich um Stanzteile handeln, die aus Blech ausgestanzt sind, wobei z.B. mehrere, miteinander verbundene Stanzteile gleichzeitig ausgestanzt werden können. Ebenso könnten vielfach Sperrglieder aus Kunststoff in einem entsprechenden Werkzeug hergestellt werden.

Der Griff kann so gestaltet und/oder aus solchem Material hergestellt sein, dass mit Hilfe einer herkömmlichen Plombierzange eine Kennung durch den Versorgungsnetzbetreiber eingebracht werden kann.

Das Sperrglied kann eine bestimmte Materialzusammensetzung aufweisen, anhand der die Echtheit, d.h. die Herkunft vom Versorgungsnetzbetreiber, nachgewiesen werden kann.

Abweichend von den gezeigten Ausführungsbeispielen könnte der Griff um 90° abgewinkelt und in eine Einsenkung einlegbar sein.

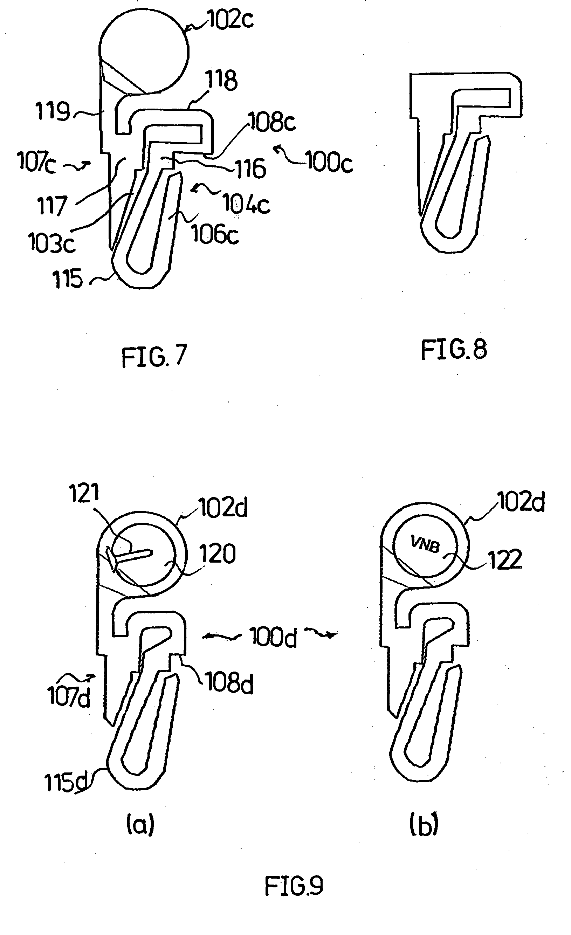

Bei dem Ausführungsbeispiel von Fig. 7 weist ein erster Schaftteil 104c eines Sperrglieds 100c einen etwa U-förmigen Abschnitt 115 auf. Ein Schenkel des U-förmigen Abschnitts 115 bildet einen Widerhaken 106c. Der andere Schenkel des U-förmigen Abschnitts 115 geht über in einen Blockabschnitt 116, welcher unmittelbar angrenzend an einen Blockabschnitt 117 eines im übrigen keilförmigen zweiten Schaftteils 107c angeordnet ist. An den Blockabschnitt 116 schließt sich unter Bildung eines Anschlags 108c ein seitlicher Vorsprung an, welcher in einen bügelförmigen Verbindungsabschnitt 118 zur Verbindung des ersten Schaftteils 104c mit dem zweiten Schaftteil 107c übergeht.

Der zweite Schaftteil 107c ist über einen Verbindungsabschnitt 119 mit einem scheibenförmigen Griff 102c verbunden. Der Verbindungsabschnitt 119 kann eine Schwachstelle aufweisen, die es ermöglicht, den Griff um 90° abzubiegen. Ein am zweiten Schaftteil 107c vorgesehener Absatz bildet einen Teil des Anschlags 108c.

Der Anschlag 108c begrenzt das Einschieben des Sperrgliedes 100c in einen Steckkanal, wobei die Rundung des U-förmigen Abschnitts 115 die Einführung des Sperrgliedes in den Steckkanal erleichtert. Während des Einschiebens wird der Widerhaken 106c des U-förmigen Abschnitts 115 nach innen gebogen. In der Anschlagstellung ist der Widerhaken an einer Hinterschneidung im Steckkanal eingerastet. An der Spitze des keilförmigen zweiten Schaftteils ist ein bündiger Übergang zum ersten Schaftteil gebildet, so dass das Einführen des Sperrgliedes 100c in den Steckkanal durch diese Spitze nicht behindert wird. Indem die Blockabschnitte 116 und 117 unmittelbar aneinander angrenzend angeordnet sind, besteht keine Möglichkeit, die Breite des Sperrgliedes unterhalb des Anschlags zu verringern, um so das Sperrglied aus dem Steckkanal zu entfernen.

Zur Aufhebung der Blockierung lässt sich der bügelförmige Verbindungsabschnitt 118 zerschneiden. Die aus dem Steckkanal vorstehenden Teile bilden vorteilhaft Griffmöglichkeiten zum bequemen Herausziehen der Teile des Sperrgliedes aus dem Steckkanal. Der in den U-förmigen Abschnitt 118 übergehende seitliche Vorsprung kann so groß sein, dass nach Zertrennung des Sperrgliedes 100c der Schaftteil 104c selbst dann nicht in den Steckkanal hineinfallen kann, wenn der Schaftteil 107c schon aus dem Steckkanal herausgezogen worden ist.

Da der durch den seitlichen Vorsprung gebildete Absatz zur Bildung des Anschlags 100c kleiner als der an dem Schaftteil 107c gebildete Absatz für die Bildung dieses Anschlags ist, könnte durch eine neben der Steckkanalöffnung angeordnete Nase verhindert werden, dass das Sperrglied 100c ungewollt verkehrt herum in den Steckkanal eingeführt wird, indem der längere Absatz gegen diese Nase anschlägt.

Am Griffteil 102c lässt sich vor Ort durch Einprägen mit einer Zange oder schon bei der Herstellung des Sperrgliedes eine Beschriftung, die z.B. den Versorgungsnetzbetreiber kenntlich macht, anbringen.

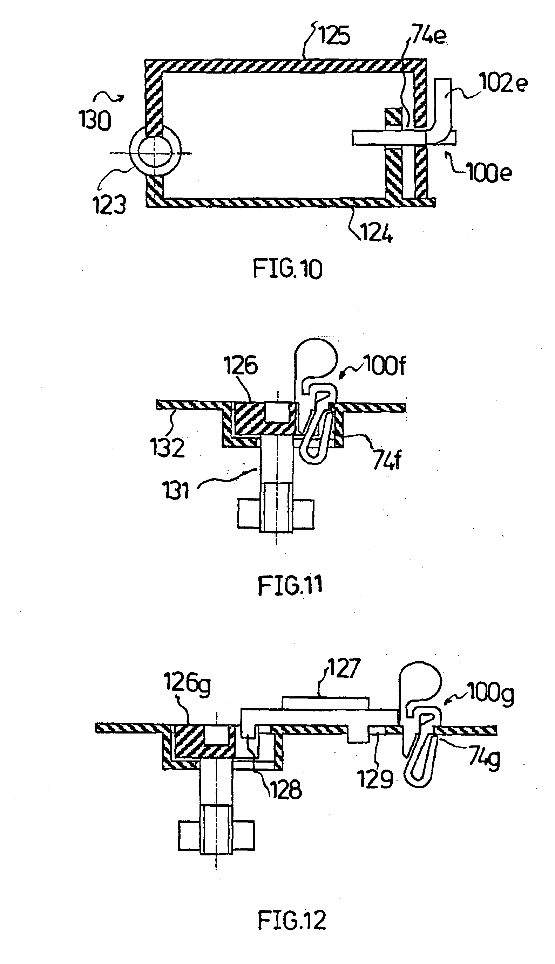

Bei dem Ausführungsbeispiel von Fig. 9 fehlt ein Griffteil. Ein solches vereinfachtes Sperrglied könnte z.B. in ausgelieferten Geräten verwendet sein. Der Installateur vor Ort sieht dann, dass an den Geräten nicht manipuliert wurde. Bei der Installation wird dieses Sperrglied durch ein Sperrglied z.B. gemäß Fig. 7 ersetzt.

Das in Fig. 9 gezeigte Ausführungsbeispiel für ein Sperrglied 100d weist wie die Sperrglieder von Fig. 7 und 8 einen U-förmig gebogenen Abschnitt 115d und einen keilförmigen zweiten Schaftteil 107d auf. Im Unterschied zu den Ausführungsbeispielen von Fig. 7 und 8 ist ein Anschlag 108d verkürzt. Ein Griffteil 102d weist eine Öffnung 120 auf, in welche ein Stift 121 hineinragt. Der Stift 121 lässt sich aus der Öffnung 120 herausbiegen, so dass eine Plombe 122 darauf aufsteckbar ist. Unter Rückbiegung des Stiftes lässt sich die Plombe in die Öffnung 120 einsetzen und durch Verpressung in der Öffnung am Sperrglied befestigen.

Die Fig. 10 bis 12 zeigen weitere Anwendungsbeispiele für Sperrglieder nach der Erfindung.

Fig. 10 zeigt einen SLS-Schalterverschluss 130 mit um ein Gelenk 123 gegeneinander verschwenkbaren Teilen 124 und 125. Öffnungen in den Teilen 124 und 125 bilden bei 74e einen Steckkanal, in den ein die gegenseitige Verschwenkung verhinderndes Sperrglied 100e eingeführt ist. In dem betreffenden Ausführungsbeispiel ist ein Griffteil 102e platzsparend um 90° abgebogen.

Fig. 11 zeigt einen Befestigungsbolzen 131, welcher der Befestigung einer Verteilerkastenabdeckung 132 dient. Ein Bolzenkopf 126 weist eine Aussparung 74f auf, in welche ein Sperrglied 100f einsteckbar ist und so den Bolzen 131 gegen Verdrehung blockiert, so dass die Bolzenverbindung nicht lösbar ist.

Bei dem Ausführungsbeispiel von Fig. 12 ist zur Blockierung eines Bolzenkopfes 126g ein Zwischenstück 127 mit einer Nase 128 vorgesehen, dass in einer Führung 129 verschiebbar und seinerseits durch ein Sperrglied 100g blockierbar ist.

## Patentansprüche

1. Sperre zur Blockierung eines Funktionselements (10;130;131) in einer gewünschten Stellung, insbesondere zur Blockierung eines Funktionselements (10) eines Stromzähleranschlussplatzes oder/und eines Stromzählers selbst, mit einem Sperrglied (100), das zur Bildung eines das Funktionselement blockierenden Anschlags in einen Steckkanal (74) einführbar und in dem Steckkanal arretierbar ist,
**dadurch gekennzeichnet,**
**dass** das Sperrglied (100) in dem Steckkanal (74) unlösbar einrastet und zur Lösung der Blockierung des Funktionselements zu zertrennen ist.

2. Sperre nach Anspruch 1,
**dadurch gekennzeichnet,**
**dass** das Sperrglied (100) einen an einer Hinterschneidung (111) im Steckkanal (74) einrastenden Widerhaken (106) aufweist.

3. Sperre nach Anspruch 1 oder 2,
**dadurch gekennzeichnet,**
**dass** das Sperrglied (100) eine Sollbruchstelle (109) aufweist.

4. Sperre nach einem der Ansprüche 1 bis 3,
**dadurch gekennzeichnet,**
**dass** das Sperrglied (100) zur Zertrennung außerhalb des Steckkanals (74) vorgesehen ist.

5. Sperre nach einem der Ansprüche 1 bis 4,
**dadurch gekennzeichnet,**
**dass** das Sperrglied (100) einen gegen den Öffnungsrand des Steckkanals (74) anlegbaren Anschlag (108) aufweist.

6. Sperre nach einem der Ansprüche 1 bis 5,
**dadurch gekennzeichnet,**
**dass** ein in den Steckkanal (74) einführbarer Schaft (101) des Sperrgliedes (100) durch Zertrennung des Sperrgliedes (100) voneinander lösbare Teile (104,107) aufweist.

7. Sperre nach Anspruch 6,
**dadurch gekennzeichnet,**
**dass** der Schaft (101) einen Längsschlitz (103) aufweist und der Schaft (101) bei Zertrennung des Sperrgliedes (100) außerhalb des Steckkanals (74) in zwei, einzeln aus dem Steckkanal (74) herausziehbare Schaftteile (104,107) zerfällt.

8. Sperre nach Anspruch 6 oder 7,
**dadurch gekennzeichnet,**
**dass** zwischen den Schaftteilen (104,107;104b,107b) starre oder/und flexible Verbindungsabschnitte (12,13) gebildet sind.

9. Sperre nach einem der Ansprüche 6 bis 8,
**dadurch gekennzeichnet,**
**dass** die Schaftteile (104,107) über einen, vorzugsweise scheibenförmigen, Griffteil (102) des Sperrgliedes (100) miteinander verbunden sind.

10. Sperre nach Anspruch 9,
**dadurch gekennzeichnet,**
**dass** die Sollbruchstelle (109) zwischen den Schaftteilen (104,107) und dem Griffteil (102) angeordnet ist.

11. Sperre nach Anspruch 7,
**dadurch gekennzeichnet,**
**dass** einer der Schaftteile (104c) einen den Widerhaken (106c) umfassenden, U-förmigen Abschnitt (115) aufweist, welcher über einen außerhalb des Steckkanals angeordneten, bügelförmigen Verbindungsabschnitt (118) mit dem anderen Schaftteil (107c) verbunden ist.

12. Sperre nach Anspruch 11,
**dadurch gekennzeichnet,**
**dass** die Schaftteile (104c,107c), vorzugsweise in einem sich in Steckrichtung an den Anschlag (108c) anschließenden Abschnitt, gegeneinander anliegen.

13. Sperre nach Anspruch 11 oder 12,
**dadurch gekennzeichnet,**
**dass** der andere Schaftteil (107c) keilförmig mit einer an den Längsschlitz (103c) angrenzenden, einem U-Schenkel des U-förmigen Abschnitts (115) gegenüberliegenden Keilfläche ausgebildet ist.

14. Sperre nach einem der Ansprüche 9 bis 13,
**dadurch gekennzeichnet,**
**dass** der Griffteil (102d) eine Öffnung (120) für die Aufnahme einer in der Öffnung fixierbaren Plombe (122) aufweist.

15. Sperre nach Anspruch 14,
**dadurch gekennzeichnet,**
**dass** in die Öffnung (120) ein Stift (121) hineinragt, welcher sich aus der Öffnung (120) herausbiegen lässt.
